Europäisches Patentamt

European Patent Office

Office européen des brevets

(19)

(11) **EP 0 610 770 B1**

(12) **EUROPÄISCHE PATENTSCHRIFT**

(45) Veröffentlichungstag und Bekanntmachung des Hinweises auf die Patenterteilung:
**09.07.1997   Patentblatt 1997/28**

(51) Int Cl.[6]: **H03K 17/62**, H03K 17/04

(21) Anmeldenummer: **94101403.7**

(22) Anmeldetag: **31.01.1994**

(54) **Multiplexeranordnung in Stromschaltertechnik**

Multiplexing circuit arrangement using current switching

Montage de multiplexage à commutation de courant

(84) Benannte Vertragsstaaten:
**DE FR GB IT NL**

(30) Priorität: **12.02.1993   DE 4304262**

(43) Veröffentlichungstag der Anmeldung:
**17.08.1994   Patentblatt 1994/33**

(73) Patentinhaber: **SIEMENS AKTIENGESELLSCHAFT**
**80333 München (DE)**

(72) Erfinder: **Friedrich, Dirk, Dipl.-Ing.**
**D-81739 München (DE)**

(56) Entgegenhaltungen:
**DE-A- 3 808 036          DE-A- 4 030 631**

- **ELEKTRONIK, Bd.36, Nr.19, 18. September 1987, MUNCHEN,DE Seiten 140 - 146 I. MARTIGNY 'GRUNDSCHALTUNGEN FUR DIGITALE, BIPOLARE HOCHGESCHWINDIGKEITS-ICS'**

**Beschreibung**

Die Erfindung betrifft eine Multiplexeranordnung mit den Merkmalen:

a) mindestens eine erste und eine zweite Gruppe von Transistoren enthalten jeweils einen ersten, einen zweiten und mindestens einen dritten Transistor,

b) die Emitter der Transistoren derselben Gruppe sind miteinander verbunden und über jeweils eine Stromquelle mit einem Anschluß für ein erstes Versorgungspotential verbunden,

c) die Kollektoren der ersten Transistoren aus jeder Gruppe sind miteinander verbunden und über einen ersten Widerstand mit einem Anschluß für ein zweites Versorgungspotential verbunden,

d) der kollektorseitige Anschluß des ersten Widerstandes ist mit einem Ausgangsanschluß verbunden,

e) die Basisanschlüsse der zweiten Transistoren jeder Gruppe sind Eingangsanschlüsse für je ein Datensignal,

f) die Basisanschlüsse der dritten Transistoren jeder Gruppe sind Anschlüsse für je ein Auswahlsignal,

g) die Auswahlsignale sind zueinander komplementäre Signale.

Eine solche Multiplexeranordnungen sind aus der deutschen Patentanmeldung DE 40 30 631 bekannt. Jeder Stromschalter enthält einen Referenztransistor, an dessen Basis ein festes Referenzpotential anliegt. Um einen ausreichenden Störabstand einzuhalten, darf ein minimaler Signalpegelhub (400mV) nicht unterschritten werden. Dies begrenzt auch die maximale Arbeitsgeschwindigkeit, da die parasitären Kollektor-Substrat-Kapazitäten über den vollen Signalpegelhub umgeladen werden müssen.

Die Aufgabe der Erfindung ist es, die bekannte Multiplexeranordnung derart zu verbessern, daß eine höhere geschwindigkeit bei gleicher Störsicherheit möglich ist.

Diese Aufgabe wird dadurch gelöst, daß

h) die Kollektoren der zweiten und dritten Transistoren derselben Gruppe miteinander verbunden sind und über je einen zweiten Widerstand mit dem Anschluß für das zweite Versorgungspotential,

i) der kollektorseitige Anschluß des zweiten Widerstandes jeder Gruppe mit der Basis des ersten Transistors der jeweiligen Gruppe verbunden ist.

Im folgenden wird die Erfindung anhand der in der Zeichnung dargestellten Figuren näher erläutert. Gleiche Schaltungsteile in verschiedenen Figuren sind dabei mit gleichen Bezugszeichen versehen. Es zeigen:

Figur 1    eine erfindungsgemäße Multiplexeranordnung,

Figur 2    eine Kompensationsschaltung für die Multiplexeran ordnung,

Figur 3    eine weitere Kompensationsschaltung für die plexeranordnung,

Figur 4    die Multiplexeranordnung in differentieller Ausführungsform und

Figur 5    eine weitere Ausführungsform der Multiplexeranordnung.

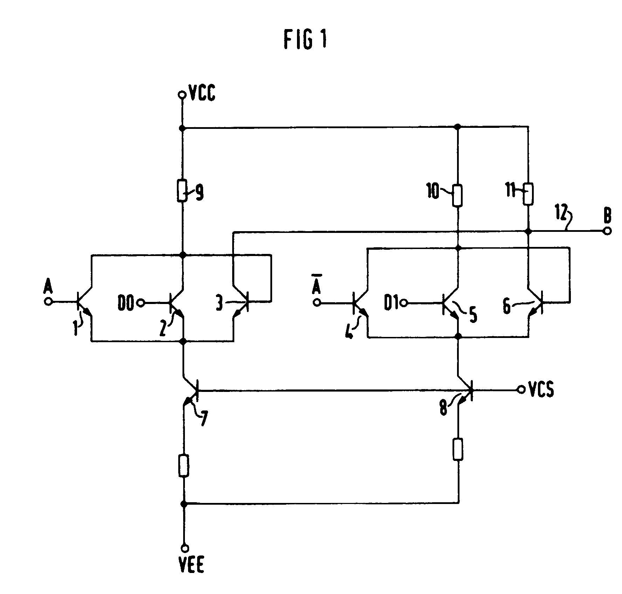

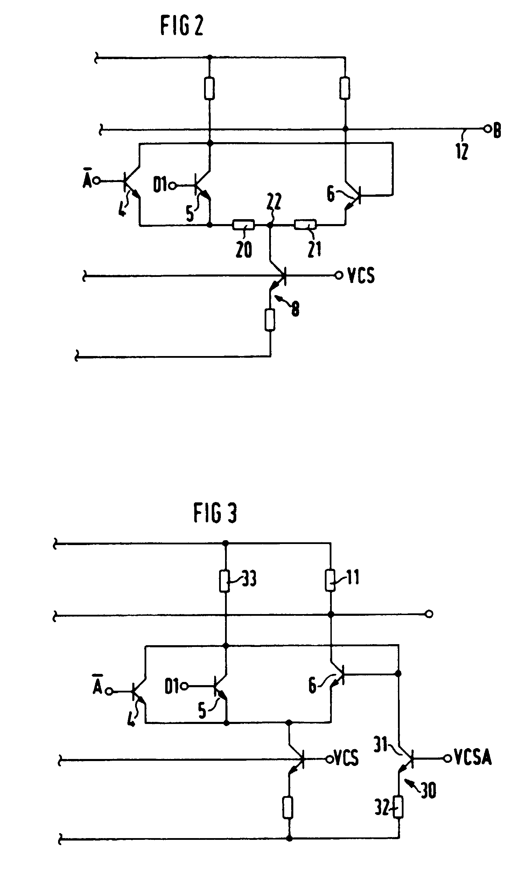

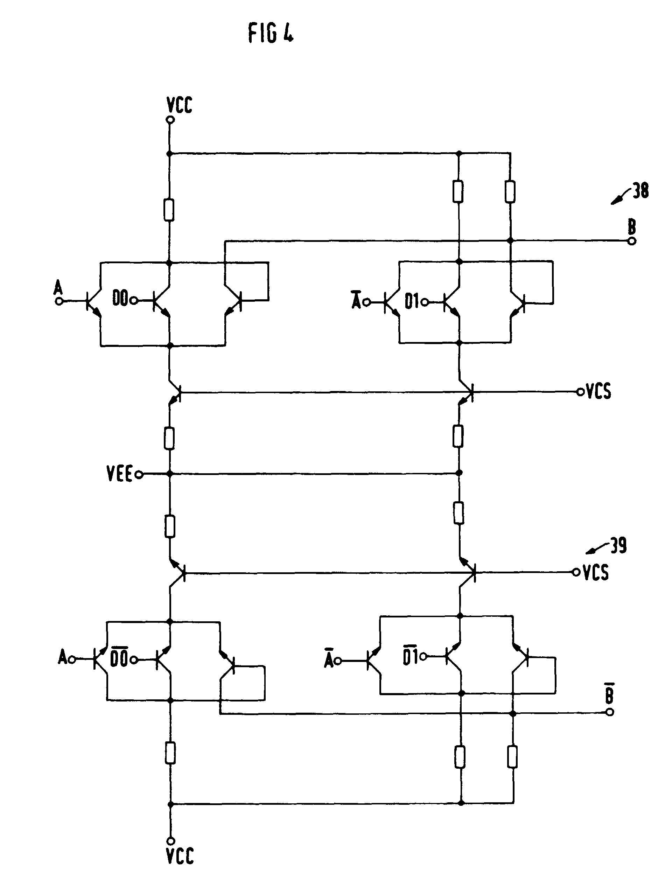

Bei dem in der Figur 1 gezeigten 2:1-Multiplexer wird in Abhängigkeit vom Auswahlsignal A eines der Eingangsdatensignale D0, D1 ausgewählt, das dann an dessen Ausgang anliegt. Der Multiplexer weist im einzelnen folgende Elemente auf: Ein erster Stromschalter enthält emittergekoppelte Transistoren 1, 2, 3, die über eine Stromquelle 7 an einen Anschluß für ein negatives Versorgungspotential VEE angeschlossen sind. Die Stromquelle enthält einen von einem festen Potential VCS gesteuerten Bipolartransistor mit emitterseitigem Widerstand. Ein zweiter Stromschalter enthält emittergekoppelte Transistoren 4, 5, 6, deren Emitter über eine Stromquelle 8 mit dem Anschluß für das Versorgungspotential VEE verbunden sind. Die Kollektor-Emitter-Strecken der Transistoren 1, 2 bzw. 4, 5 des ersten und zweiten Stromschalters sind parallel geschaltet. Ihre Kollektoren sind über je einen Widerstand 9, 10 an einen Anschluß für ein positives Versorgungspotential VCC angeschlossen. Die Basis des Transistors 1, wird von einem Auswahlsignal A gesteuert, die Basis des Transistors 4 vom komplementären Auswahlsignal $\bar{A}$. An den Basisanschlüssen der Transistoren 2, 5 liegen Dateneingangssignale D0 bzw. D1 an. Die Kollektoren der Transistoren 3, 6 sind miteinander verbunden und über einen Widerstand 11 mit dem Anschluß für das Versorgungspotential VCC verbunden. Die Kollektoren der Transistoren 3, 6 sind außerdem mit einem Ausgangsanschluß 12 verbunden, der das Ausgangssignal B führt. Die Basisanschlüsse der Transistoren 3, 6 sind jeweils mit dem kollektorseitigen Anschluß des Widerstandes 9 bzw. 10 verbunden.

Die Schaltung arbeitet folgendermaßen: Wenn das Auswahlsignal A einen L-Pegel führt, ist der Transistor 1 gesperrt. Wenn das Signal D0 H ist, ist der Transistor 2 leitend, so daß der Strom der Stromquelle 7 durch den Transistor 2 fließt. Der kollektorseitige Anschluß des Widerstandes 9 liegt auf L-Potential, so daß der Transistor 3 gesperrt ist. Dadurch wird das Ausgangssignal B am Ausgang 12 auf H eingestellt. Wenn das Eingangssignal D0 L ist, ist der Transistor 2 gesperrt, so daß der kollektorseitige Anschluß des Widerstandes 9 auf H liegt. Dadurch ist der Transistor 3 leitend, so daß der Strom der Stromquelle 7 durch den Widerstand 11 und den Transistor 3 fließt. Dadurch stellt sich das Signal B am Ausgang 12 auf L ein. Demzufolge wird bei einem L-Pegel des Signals A vom 2:1-Multiplexer das Eingangssignal D0 ausgewählt und erscheint als Ausgangssignal B am Ausgang 12.

Führt das Auswahlsignal A einen H-Pegel, fließt der Strom der Stromquelle 7 unabhängig vom Zustand des Signals D0 bzw. dem Schaltzustand des Transistors 2 durch den Transistor 1. Der Signalpegel des Signals D0 hat dann keinen Einfluß auf das Ausgangssignal B. Das Signal $\overline{A}$ an der Basis des Transistors 4 ist nun L, so daß sich das Ausgangssignal B gemäß dem Eingangssignal D1 einstellt.

Dadurch, daß die Basis des Transistors 3 mit den Kollektoren 1, 2 verbunden ist, ergibt sich für den als Differenzverstärker ausgeführten Stromschalter aus den Transistoren 1, 2, 3 und der Stromquelle 7 eine Mitkopplung. Durch die Mitkopplung wird die Verstärkung des Differenzverstärkers erhöht. Dies bedeutet, daß die Transferkurve des Differenzverstärkers, das heißt die Kennlinie des Signals am Kollektor des Transistors 3 betrachtet in Abhängigkeit von einem der Signale A und D0, steiler verläuft. Entsprechendes gilt für den Stromschalter bestehend aus den Transistoren 4, 5, 6 und der Stromquelle 8. Der erfindungsgemäße Multiplexer hat demnach gegenüber dem bekannten Multiplexer den Vorteil eines höheren Störabstandes bei gleichem Signalpegel. Andererseits bedeutet dies, daß der Signalpegel gegenüber dem bekannten Multiplexer bei gleicher Störsicherheit verringert werden kann. Aufgrund eines geringeren Signalpegelhubs sind die zur Umladung der parasitären Kollektor-Substrat-Kapazitäten der Schalttransistoren notwendigen Umladeströme während eines Umschaltvorgangs geringer. Dies hat insgesamt zur Folge, daß die Arbeitsgeschwindigkeit gegenüber dem bekannten Multiplexer erhöht ist. Außerdem reicht zur Erzielung eines geringeren Signalpegelhubs bei vergleichbarem Widerstandswert des Arbeitswiderstandes 11 ein geringerer, von den Stromquellen 7, 8 zu liefernder Strom aus. Die Verlustleistung wird demnach reduziert.

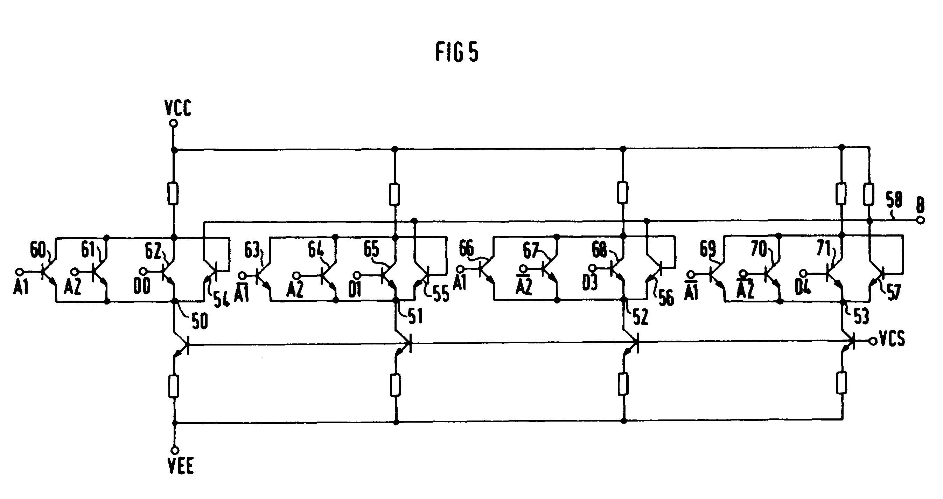

Der Multiplexer nach Figur 1 hat die Eigenschaft, daß Hysterese auftritt, wenn die Stromschalter übersteuert betrieben werden, das heißt, daß die Signalpegel der Eingangs- und Ausgangssignale im übersteuerten Bereich der Transferkurve liegen. Der größtmögliche Signalpegelhub für den Betrieb ohne Hysterese liegt bei etwa der vierfachen Temperaturspannung (ca. 100 mV). Für einen darüber hinausgehenden Signalpegelhub werden Kompensationsschaltungen notwendig, damit weiterhin ein Betrieb ohne Hysterese möglich ist. In den Figuren 2, 3 sind zwei mögliche Arten zur Kompensation der bei vergrößerten Signalpegelhüben auftretenden Schalthysteresen gezeigt. Dabei ist aus Gründen der Übersichtlichkeit nur jeweils einer der beiden einen 2:1-Multiplexer bildenden Stromschalter gezeigt.

Eine erste Ausführungsform der Kompensation ist in Figur 2 dargestellt. Hierzu ist zwischen den Anschluß 22 der Stromquelle 8 und die gekoppelten Emitter der Transistoren 4, 5 ein Widerstand 20 geschaltet, zwischen den Anschluß 22 und den Emitter des Transistors 6 ein weiterer Widerstand 21. In entsprechender Weise ist - nicht dargestellt - zwischen den Emittern der Transistoren 1, 2 und dem entsprechenden Anschluß der Stromquelle 7 und dem Emitter des Transistors 3 und dem Anschluß der Stromquelle 7 je ein Widerstand angeordnet. Durch die Widerstände 20, 21 wird im Differenzverstärker der Transistoren 4, 5, 6 und der Stromquelle 8 eine Gegenkopplung bewirkt. Die Emitterpotentiale der emittergekoppelten Transistoren 4, 5 und 6 sind nunmehr durch den Spannungsabfall an den Widerständen 20, 21 voneinander verschoben, so daß dadurch der mögliche Wertebereich des Signalpegelhubs, für den der Stromschalter ohne Hysterese arbeitet, vergrößert ist.

Bei der Kompensationsschaltung der Figur 3 wird an der Basis des Transistors 6 durch eine Stromquelle 30, die zwischen der Basis des Transistors 6 und dem Anschluß für das Versorgungspotential VCC angeordnet ist, ein Kompensationsstrom eingespeist. Die Stromquelle 30 enthält einen Transistor 31 mit emitterseitigem Widerstand 32. Die Basis des Transistors 31 ist mit einem weiteren festen Potential VCSA verbunden. Das Potential VCSA kann gleich dem Potential VCS sein und auch von der gleichen Potentialquelle geliefert werden. Die in den Kollektorzweigen der Transistoren 4, 5 bzw. 6 angeordneten Widerstände 33, 11 weisen nun im Gegensatz zu den bisherigen Ausführungsbeispielen verschiedene Widerstandswerte auf. Der Widerstand 33 hat einen kleineren Wert als der Widerstand 11. Durch den zusätzlich durch den Widerstand 33 fließenden Strom der Kompensationsstromquelle 30 im Zusammenhang mit verschiedenen Werten der Widerstände 33, 11 wird erreicht, daß der Pegelwert des L-Pegels an der Basis des Transistors 6 höher liegt als der Wert des L-Pegels der Ein- und Ausgangssignale und daß der Pegelwert des H-Pegels an der Basis des Transistors 6 niedriger liegt als der Pegelwert des H-Pegels der Ein- und Ausgangssignale. Somit wird erreicht, daß der Signalpegelhub der Ein- und Ausgangssignalpegel in einem größeren Wertebereich das Umschalten der Stromschalter ohne Hysterese erlaubt. Es ist dabei wichtig, daß das Widerstandsverhältnis der Widerstände 33, 31 und der von der Kompensationsstromquelle 30 eingeprägte Strom in Abhängigkeit voneinander derart dimensioniert werden, daß der L- und H-Pegel des an der Basis des Transistors 6 anliegenden Signals und der L- und H-Pegel der Ein- und Ausgangssignale jeweils symmetrisch um den gleichen Mittelwert liegen. Der Mittelwert ist gleich der Schaltschwelle des Stromschalters.

Eine differentielle Ausführungsform eines erfindungsgemäßen Multiplexers ist in der Figur 4 gezeigt. Er enthält zwei gemäß der Figur 1 aufgebaute Multiplexer 38, 39. Die einander entsprechenden Eingangsanschlüsse für die Auswahlsignale beider Multiplexer 38, 39 werden von den Signalen A, A gleichphasig gesteuert. Die einander entsprechenden Eingänge für die Datensignale der Multiplexer 38, 39 werden von komplementären Datensignalen gesteuert. Dies bedeutet, daß dem Multiplexer 38 die Datensignale D0, D1 zugeführt werden, dem Multiplexer 39 an den entsprechenden Eingängen die komplementären Datensignale $\overline{D0}$, $\overline{D1}$. Die in den Figuren 2, 3 gezeigten Kompensationsschaltungen sind entsprechend auch auf die in den Multiplexern 38, 39 enthaltenen Stromschalter anwendbar.

Die in den Figuren gezeigten Ausführungsformen betreffen jeweils 2:1-Multiplexer. Mit der erfindungsgemäßen Realisierung sind auch N:1-Multiplexer für N Dateneingangssignale und ein Ausgangssignal möglich. Dabei ist N die M-te Potenz von 2 ($2^M$), wobei M eine ganze Zahl größer oder gleich 2 ist. In der Figur 5 ist stellvertretend ein 4:1-Multiplexer dargestellt. Im N:1-Multiplexer sind N Stromschalter 50, 51, 52, 53 enthalten, bei denen jeweils die Kollektoren des an seiner Basis rückgekoppelten Schalttransistors 54, 55, 56, 57 gemeinsam an den Ausgangssignalanschluß 58 angeschlossen sind. Jeder Stromschalter enthält M+1 weitere mit den Kollektor-Emitter-Strecken parallel geschaltete Transistoren 60, ..., 71. Je ein Transistor der weiteren Transistoren eines Stromschalters wird von einem Dateneingangssignal D0, ..., D3 gesteuert, die anderen M Transistoren von Auswahlsignalen. Insgesamt ist eine Anzahl von M verschiedenen Auswahlsignalen A1, A2 und den M dazu komplementären Signalen $\overline{A1}$, $\overline{A2}$ vorhanden. Die Auswahltransistoren jedes Stromschalters werden von einer Kombination von M Signalen gesteuert, wobei diese Kombination aus den 2 . M Auswanlsignalen und dazu komplementären Signalen ausgewählt wird. Jede Kombination ist jeweils derart, daß bei beliebigen Auswahlsignalwerten nur bei jeweils einem einzigen Stromschalter alle M Auswahltransistoren gesperrt sind. Das betreffende Dateneingangssignal ist dann ausgewählt und liegt am Ausgang 58 an. Dies wird dadurch erreicht, daß die Kombination aus den Auswahlsignalen und den dazu komplementären Signalen nur ein einziges Mal auftritt. Die erste Kombination für den Stromschalter 50 umfaßt also A1, A2, die zweite Kombination für den Stromschalter 51 $\overline{A1}$, A2 die dritte Kombination für den Stromschalter 52 A1, $\overline{A2}$ usw.

Auch bei einem N:1-Multiplexer ist eine differentielle Ausführung oder die Verwendung von Kompensationsschaltungen möglich. Ein N:1-Multiplexer hat den Vorteil, daß die gnalverzögerungszeiten von allen Eingängen für die Daten- und Auswahlsignale zum Ausgang jeweils gleich sind.

Aus einem 2:1-Multiplexer gemäß der Figur 1 kann ein taktzustandsgesteuertes Speicherelement erhalten werden, indem der Ausgang auf einen der Datensignaleingänge rückgekoppelt wird.

## Patentansprüche

1. Multiplexeranordnung mit den Merkmalen:

    a) mindestens eine erste und eine zweite Gruppe von Transistoren enthalten jeweils einen ersten, einen zweiten und mindestens einen dritten Transistor (3, 2, 1; 6, 5, 4)

    b) die Emitter der Transistoren derselben Gruppe sind miteinander verbunden und über jeweils eine Stromquelle (7; 8) mit einem Anschluß für ein erstes Versorgungspotential (VEE) verbunden,

    c) die Kollektoren der ersten Transistoren (3; 6) aus jeder Gruppe sind miteinander verbunden und über einen ersten Widerstand (11) mit einem Anschluß für ein zweites Versorgungspotential (VCC) verbunden,

    d) der kollektorseitige Anschluß des ersten Widerstandes (11) ist mit einem Ausgangsanschluß (12) verbunden,

    e) die Basisanschlüsse der zweiten Transistoren (2; 5) jeder Gruppe sind Eingangsanschlüsse für je ein Datensignal (D0; D1),

    f) die Basisanschlüsse der dritten Transistoren (1; 4) jeder Gruppe sind Anschlüsse für je ein Auswahlsignal (A; $\overline{A}$),

    g) die Auswahlsignale (A; $\overline{A}$) sind zueinander komplementäre Signale,

**dadurch gekennzeichnet**, daß

    h) die Kollektoren der zweiten und dritten Transistoren (2, 1; 5, 4) derselben Gruppe miteinander verbunden sind und über je einen zweiten Widerstand (9; 10) mit dem Anschluß für das zweite Versorgungspotential (VCC),

    i) der kollektorseitige Anschluß des zweiten Widerstandes (9; 10) jeder Gruppe mit der Basis des ersten Transistors (3; 6) der jeweiligen Gruppe verbunden ist.

2. Multiplexeranordnung nach Ansprucn 1, **dadurch gekennzeichnet,** daß der Widerstandswert der zweiten Widerstände (9; 10) jeweils kleiner ist als der Widerstandswert des ersten Widerstandes (11) und daß zwischen den Basisanschlüssen der ersten Transistoren (3; 6) jeder Gruppe und dem Anschluß für das erste Versorgungspotential (VEE) je eine Stromquelle (30) geschaltet ist.

3. Multiplexeranordnung nach Anspruch 1, **dadurch gekennzeichnet,** daß in jeder Gruppe zwischen dem Emitter des ersten Transistors (3; 6) und dem emitterseitigen Anschluß (22) der Stromquelle (7, 8) ein Widerstand (21) geschaltet ist und daß in jeder Gruppe zwischen den Emittern der zweiten und dritten Transistoren (1, 2; 4, 5) und dem genannten emitterseitigen Anschluß (22) der Stromquelle je ein Widerstand (20) geschaltet ist.

4. Multiplexeranordnung nach einem der Ansprücne 1 bis 3, **dadurch gekennzeichnet,** daß mindestens N Gruppen von Transistoren (50; 51; 52; 53) vorhanden sind, wobei N = $2^M$ ist und M eine ganze Zanl größer als 1 ist, daß jede Gruppe M-1 weitere Transistoren (60; 63; 66; 69) enthält, deren Kollektor-Emitter-Strecken der Kollektor-Emitter-Strecke des dritten Transistors (61; 64; 67; 70) parallel geschaltet sind, daß M Auswahlsignale (A1, A2) und deren komplementäre Signale ($\overline{A1}$, $\overline{A2}$) vorhanden sind, daß die Basisanschlüsse der M-1 weiteren Transistoren und des dritten Transistors jeder Gruppe von je einer anderen Kombination von M Signalen aus den Auswahlsignalen und komplementären Signalen gesteuert werden.

5. Multiplexeranordnung nach einem der Ansprücne 1 bis 4, **gekennzeichnet durch** differentielle Ausführung, bei der die sich entsprechenden Auswahlsignale paarweise gleich sind und die sich entsprechenden Datensignale paarweise komplementär sind.

**Claims**

1. Multiplexer arrangement having the features:

   a) at least one first and one second group of transistors in each case contain a first, a second and at least a third transistor (3, 2, 1; 6, 5, 4)
   b) the emitters of the transistors of the same group are connected to one another and are connected via a respective current source (7; 8) to a terminal for a first supply potential (VEE),
   c) the collectors of the first transistors (3; 6) from each group are connected to one another and are connected via a first resistor (11) to a terminal for a second supply potential (VCC),
   d) the collector-side terminal of the first resistor (11) is connected to an output terminal (12),
   e) the base terminals of the second transistors (2; 5) of each group are input terminals for a respective data signal (D0; D1),
   f) the base terminals of the third transistors (1; 4) of each group are terminals for a respective selection signal (A; $\overline{A}$),
   g) the selection signals (A; $\overline{A}$) are mutually complementary signals,

   characterized in that

   h) the collectors of the second and third transistors (2, 1; 5, 4) of the same group are connected to one another and, via a respective second resistor (9; 10), to the terminal for the second supply potential (VCC),
   i) the collector-side terminal of the second resistor (9; 10) of each group is connected to the base of the first transistor (3; 6) of the respective group.

2. Multiplexer arrangement according to Claim 1, characterized in that the resistance of the second resistors (9; 10) is in each case less than the resistance of the first resistor (11), and in that a respective current source (30) is connected between the base terminals of the first transistors (3; 6) of each group and the terminal for the first supply potential (VEE).

3. Multiplexer arrangement according to Claim 1, characterized in that a resistor (21) is connected in each group between the emitter of the first transistor (3; 6) and the emitter-side terminal (22) of the current source (7, 8), and in that a respective resistor (20) is connected in each group between the emitters of the second and third transistors (1, 2; 4, 5) and the said emitter-side terminal (22) of the current source.

4. Multiplexer arrangement according to one of Claims 1 to 3, characterized in that at least N groups of transistors (50; 51; 52; 53) are present, where N = $2^M$ and M is an integer greater than 1, in that each group contains M-1 further transistors (60; 63; 66; 69) whose collector-emitter paths are connected in parallel with the collector-emitter path of the third transistor (61; 64; 67; 70), in that M selection signals (A1, A2) and their complementary signals ($\overline{A1}$, $\overline{A2}$) are present, in that the base terminals of the M-1 further transistors and of the third transistor of each group are controlled in each case by a different combination of M signals from the selection signals and complementary signals.

5. Multiplexer arrangement according to one of Claims 1 to 4, characterized by a differential design in which the mutually corresponding selection signals are identical in pairs and the mutually corresponding data signals are complementary in pairs.

**Revendications**

1. Montage de multiplexage ayant les caractéristiques suivantes :

   a) au moins un premier et un deuxième groupe de transistors comportent chacun un premier, un deuxième et au moins un troisième transistor (3, 2, 1 ; 6, 5, 4),
   b) les émetteurs des transistors du même groupe sont reliés entre eux et, par l'intermédiaire de respectivement une source de courant (7 ; 8) , à une borne pour un premier potentiel d'alimentation (VEE),
   c) les collecteurs des premiers transistors (3 ; 6) parmi chaque groupe sont reliés entre eux et, par l'intermédiaire d'une première résistance (11), à une borne pour un deuxième potentiel d'alimentation (VCC),

d) la borne disposée du côté du collecteur de la première résistance (11) est reliée à une borne de sortie (12),

e) les bornes de la base des deuxièmes transistors (2 ; 5) de chaque groupe sont des bornes d'entrée pour respectivement un signal de données (D0, D1),

f) les bornes de la base des troisièmes transistors (1 ; 4) de chaque groupe sont des bornes pour respectivement un signal de sélection (A; $\overline{A}$),

g) les signaux de sélection (A ; $\overline{A}$) sont des signaux complémentaires,

caractérisé en ce que

h) les collecteurs des deuxièmes et troisièmes transistors (2, 1 ; 5, 4) du même groupe sont reliés entre eux et, par l'intermédiaire de respectivement une deuxième résistance (9 ; 10) à la borne pour le deuxième potentiel d'alimentation (VCC),

i) la borne disposée du côté du collecteur de la deuxième résistance (9 ; 10) de chaque groupe est reliée à la base du premier transistor (3 ; 6) du groupe respectif.

2. Montage de multiplexage selon la revendication 1, caractérisé en ce que la valeur de résistance des deuxièmes résistances (9 ; 10) est à chaque fois inférieure à la valeur de résistance de la première résistance (11) et en ce que respectivement une source de courant (30) est montée entre les bornes de la base des premiers transistors (3 ; 6) de chaque groupe et la borne pour le premier potentiel d'alimentation (VEE).

3. Montage de multiplexage selon la revendication 1, caractérisé en ce qu'une résistance (21) est montée dans chaque groupe entre l'émetteur du premier transistor (3 ; 6) et la borne (22) de la source de courant (7, 8) disposée du côté de l'émetteur et en ce que respectivement une résistance (20) est montée dans chaque groupe entre les émetteurs des deuxièmes et troisièmes transistors (1, 2 ; 4, 5) et ladite borne (22) de la source de courant disposée du côté de l'émetteur.

4. Montage de multiplexage selon l'une des revendications 1 à 3, caractérisé en ce qu'il existe au moins N groupes de transistors (50 ; 51 ; 52 ; 53), N = $2^M$ et M étant un nombre entier supérieur à 1, en ce que chaque groupe comporte M - 1 transistors supplémentaires (60 ; 63 ; 66 ; 69) dont les lignes collecteur-émetteur sont montées en parallèle avec la ligne collecteur-émetteur du troisième transistor (61 ; 64 ; 67 ; 70), en ce qu'il existe M signaux de sélection (A1, A2) et signaux complémentaires ($\overline{A1}$, $\overline{A2}$) de ceux-ci, en ce que les bornes de la base des M - 1 transistors supplémentaires et du troisième transistor de chaque groupe sont commandées par respectivement une autre combinaison de M signaux choisis parmi les signaux de sélection et les signaux complémentaires.

5. Montage de multiplexage selon l'une des revendications 1 à 4, caractérisé par une réalisation différentielle, dans laquelle les deux signaux de sélection équivalents sont identiques et forment un couple et les deux signaux de données équivalents sont complémentaires et forment un couple.

# FIG 1

## FIG 2

## FIG 3

FIG 4

FIG 5

EP 0 610 770 B1